**Europäisches Patentamt**

**European Patent Office**

**Office européen des brevets**

(19)

(11) Numéro de publication: **0 053 561**
**A2**

# (12) DEMANDE DE BREVET EUROPEEN

(21) Numéro de dépôt: **81401912.1**

(22) Date de dépôt: **02.12.81**

(51) Int. Cl.³: **G 06 F 11/22**, G 01 R 31/28

(30) Priorité: **03.12.80 FR 8025619**

(43) Date de publication de la demande: **09.06.82**
**Bulletin 82/23**

(84) Etats contractants désignés: **AT BE CH DE FR GB IT LI LU NL SE**

(71) Demandeur: **Lazare, René, 17 Domaine de Villennes, F-78670 Villennes (FR)**

(72) Inventeur: **Lazare, René, 17 Domaine de Villennes, F-78670 Villennes (FR)**

(74) Mandataire: **Thibon-Littaye, Annick, Cabinet A. THIBON-LITTAYE 11 rue de l'Etang, F-78160 Marly Le Roi (FR)**

(54) **Testeur spécifique modulaire, automatisé et portable.**

(57) La présente invention concerne un testeur modulaire, automatisé et portable, constitué d'un micro-ordinateur programmé pour l'analyse d'une série de test spécifiques destinés à contrôler le bon fonctionnement d'un matériel électronique.

L'ensemble se présente sous forme d'une valise portable qui renferme:

— une série de cartes de test interchangeables destinées à acquérir et à traiter les mesures physiques, analogiques ou numériques,

— un micro-ordinateur (4) organisé autour d'un microprocesseur (5),

— un panneau de contrôle (8) et des moyens de visualisation d'instructions et de résultats en fonction des tests commandés par l'opérateur.

Testeur spécifique modulaire, automatisé et portable.

La présente invention concerne un testeur modulaire spécifique, automatisé et portable, destiné à contrôler le bon fonctionnnement d'un matériel électrique ou électronique ; le testeur comporte notamment une série de modules de testsnumériques et analogiques reliés à un microordinateur construit autour d'un microprocesseur. Ce microordinateur est connecté à un panneau de contrôle dont la configuration peut varier en fonction de la nature des modules utilisés pour chaque test. Ce panneau permet à l'opérateur de commander l'ensemble de l'appareil , qui se présente sous forme d'une valise portable. Cette dernière peut éventuellement être complétée par une alimentation électrique autonome facilitant son fonctionnement sur les aires d'essais.

On sait que les interventions de maintenance et de contrôle réalisées sur des matériels coûteux ou stratégiques doivent, d'une part intervenir dans un minimum de temps et, d'autre part, être indépendantes des facteurs humains, par exemple le niveau technique de l'équipe d'intervention.

De plus, il est connu que le nombre de tests appliqués pour un diagnostic précis doit être restreint ; on constate en effet que l'augmentation de ce nombre diminue la fiabilité du diagnostic et augmente le coût de la maintenance.

Enfin, pour pallier les défaillances de l'électronique chargée du calcul opérationnel dans le matériel, il faut pouvoir lui substituer un calculateur extérieur spécialisé dans la même fonction et servant d'auto-contrôle lors des tests en simulation.

Toutes ces conditions entraînent la réalisation d'un système de tests spécifiques et exigent l'emploi d'automates programmés pour une maintenance particulière, situés de préférence à l'extérieur des installations électroniques contrôlées.

On connait déjà des dispositifs de contrôle d'installations électroniques complexes utilisant le principe des tests spécifiques appliqués sur le matériel à tester, dont on simule le fonctionnement.

Jusqu'à ce jour, ces dispositifs de contrôle par tests, se composent principalement d'un ordinateur à poste fixe qui analyse les réponses électriques du matériel dont le fonctionnement est simulé. Afin d'atténuer le coût de la maintenance, l'ordinateur contient différents programmes de tests spécifiques correspondant à la nature des matériels contrôlés.

Les industries qui utilisent cette organisation ne peuvent assurer la maintenance des matériels fabriqués qu'au moment de leur sortie d'usine. Tout contrôle ultérieur nécessite le transport, soit de l'ordinateur chargé d'appliquer les tests spécifiques et d'en analyser les réponses, soit des matériels à contrôler. Il est toutefois, dans des installations très complexes, possible d'utiliser une informatique de réseau constituée d'un ordinateur central de maintenance et d'un réseau périphérique spécialisé réparti sur les sites, près des matériels à tester.

Afin d'éviter ces contraintes, certains dispositifs de contrôle par tests sont construits sous forme d'ensemble portable.

L'électronique de ces testeurs, réalisée à partir d'un processeur câblé, présente une limite dans l'intégration des données. Cette caractéristique diminue considérablement la possibilité du testeur et la souplesse de son fonctionnement.

Pour pallier ces inconvénients, la présente invention propose un nouveau testeur à modules, automatisé et portable, réalisé à partir d'un microordinateur associé à un microprocesseur. Ce microordinateur et sa mémoire constituent un ensemble à haut pouvoir d'intégration qui, branché d'une part à l'électronique d'instrumentation, et d'autre part au panneau de commande, se loge dans une valise de faible encombrement. Ce dispositif modulaire de maintenance présente une grande souplesse de fonctionnement, et des possibilités illimitées de mémorisation.

Réalisée à partir d'éléments de base, la valise de maintenance est rendue spécifique, suivant le type de matériel à tester, au moyen de modules appropriés permettant aux entreprises d'équiper en permanence les sites d'exploitation d'un testeur extérieur portable adapté aux matériels à contrôler.

Programmée pour un nombre de tests limité et pertinent, cette valise présente une grande facilité d'emploi, et elle permet d'établir un diagnostic fiable indépendamment de la valeur technique de l'équipe de maintenance.

Ces avantages et caractéristiques apparaîtront plus clairement à l'issue de la description détaillée qui suit, ainsi qu'avec les dessins annexés au moyen desquels une forme de réalisation de l'invention est illustrée à titre d'exemple. Il doit cependant être expressément entendu que ces dessins ne sont donnés qu'à des fins d'illustration et ne doivent pas être interprétés comme définissant les limites de l'invention.

En se reportant aux dessins, on trouve :

- sur la figure 1 un schéma synoptique montrant l'organisation générale interne du testeur portable construit autour de son unité centrale et de ses modules de génération

- 4 -

0053561

et de réception de signaux.

- sur la figure 2 un exemple d'un panneau de contrôle et
de commande du testeur.

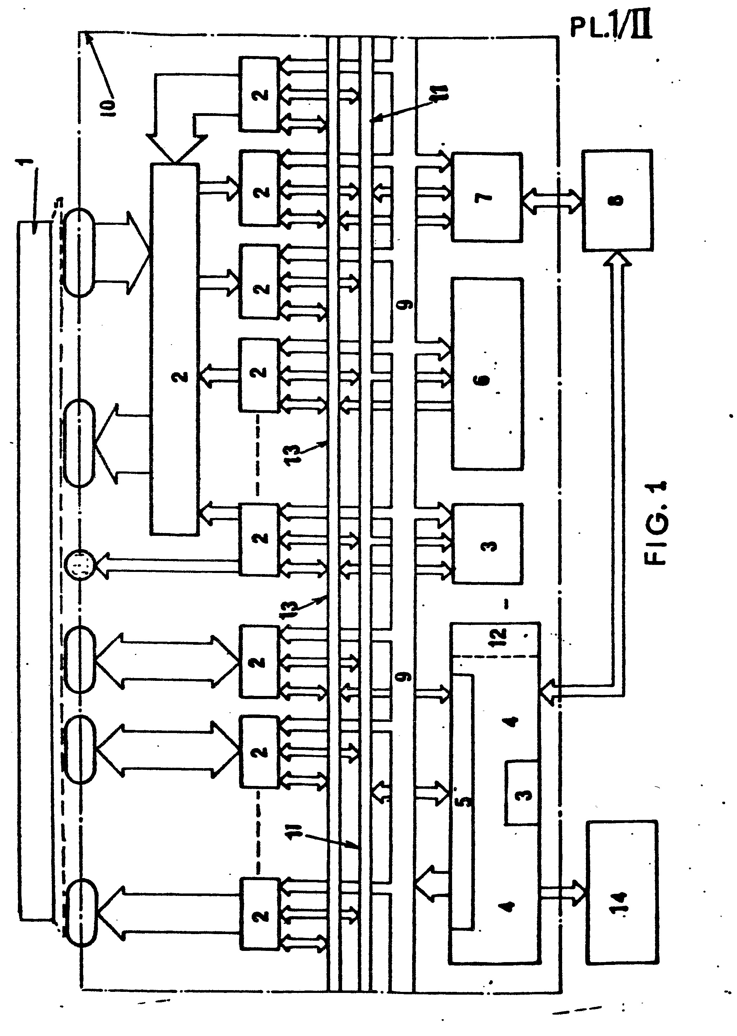

On a représenté sur la figure 1 une shéma synoptique de
l'organisation interne du testeur. Cet appareil est disposé à l'intérieur d'une valise portable symbolisée en
10 et alimentée par un générateur de courant non représenté.

Le matériel à tester, figuré en 1, est raccordé à cette
valise 10 au moyen d'un ensemble de broches 40-45, éventuellement par l'intermédiaire d'un dispositif adaptateur
A l'intérieur de la valise 10 le dispositif comprend,
dans sa formule de base, une unité centrale 4 constituée
par une carte microordinateur de référence MM19. Ce microordinateur complet regroupe sur un même circuit un microprocesseur 5 (référence MC 6809), des emplacements réservés pour une mémoire programmée 3 et une mémoire de calcul
programmable 3, des interfaces type série et type parallèle, des circuits servant à connecter les horloges nécessaires au fonctionnement des systèmes, un compteur
programmable, des liaisons BUS, ainsi que des circuits
de contrôle et de visualisation.

Le microordinateur MM 19 4 utilise le microprocesseur 8
bits MC 6809 5, microprocesseur du commerce qui contient
8 registres internes : 4 sur 8 bits (accumulateurs A et B,
un registre d'état et un registre de page ) et 4 sur 16
bits (2 registres d'index Y et X et 2 registres "pointeurs
piles", l'un pour l'utilisateur (U) et l'autre pour le
système (S).

Les broches de ce module sont utilisées pour connecter les
lignes d'interruption masquables (IRQ) et non masquables
(NMI), et une ligne à interruption rapide (FIRQ). Cette
dernière sert alors à stocker uniquement le contenu du registre d'état (CC) et celui du compteur ordinal dans la pile afin d'éviter de mémoriser les autres registres.

Le registre d'état basé sur 8 bits possède 2 bits destinés d'une part à autoriser ou inhiber le signal F1RQ, et d'autre part à caractériser une interruption standard (IRQ) par rapport à une interruption rapide (FIRQ). Il contient également plusieurs bits destinés à informer l'unité centrale de l'état du système.

L'emploi des quatre registres X, Y, U et S permet d'utiliser 19 modes d'adressage, par exemple adressage direct, indexé, incrémenté, etc... Ces modes d'adressage sont destinés à opérer aisément sur toute la mémoire divisée en 256 pages de 256 octets.

Le microprocesseur possède l'adressage indexé avec des déplacements situés sur 0, 5, 8 ou 16 bits. De plus, cet adressage indexé peut être soit indirect, soit effectué avec comme déplacement le contenu des accumulateurs A, B ou D (réunion de A + B).

Le microprocesseur utilisé contient 59 types d'instructions qui, par l'utilisation de 4 registres à 16 bits et des modes d'adressage variés, portent le nombre d'instructions à 1464. Ainsi, le transfert d'instruction d'un registre $R_1$ sur un registre $R_2$ existe sous 42 formes différentes, certaines instructions opérant sur l'accumulateur D. Le microprocesseur, qui s'adapte à un périphérique rapide, possède une instruction effectuant le changement de l'adresse effective (LEA) calculée sous forme indexée. Enfin, une instruction de synchronisation du logiciel avec le périphérique est obtenue par l'intermédiaire d'une ligne d'interruption (SYNC).

Le microordinateur 4 comporte 2 entrées et sorties type parallèle et type série, destinées à assurer la liaison avec les périphériques. Pour ces derniers on a représenté sur la figure 1, d'une part un panneau de contrôle 8, qui peut comporter notamment des boutons-poussoir pour la mise en route et les commandes essentielles, un dispositif d'arrêt d'urgence et des lampes de visualisation des résultats du test, et d'autre part des organes de dialogue 14 qui comprennent en particulier un clavier permettant à l'opérateur d'introduire certaines instructions de commande dans le déroulement d'un programme de tests et un afficheur placé sous la commande du microordinateur, par exemple pour indiquer à l'opérateur des consignes pour la poursuite d'un test ou pour lui proposer un choix entre plusieurs instructions. Contrairement aux cartes électroniques disposées à l'intérieur de la valise 10, le panneau de contrôle 8, et les organes de dialogue 14 sont montés sur une face visible de cette valise, éventuellement sous un couvercle protecteur amovible, pour être accessibles à l'opérateur. Les broches 40 à 45 qui permettent la connexion avec un matériel à tester 1, sont également montées à travers une face visible de la valise 10, ainsi d'ailleurs qu'un connecteur qui n'a pas été représenté et qui permet de placer sous la commande du microordinateur une imprimante de transcription des programmes ou des résultats des tests, venant en complément des organes de dialogue 14.

La valise 10, contient un certain nombre de cartes ou modules d'instrumentation, interchangeables, positionnées dans des casiers ménagés à cet effet. Ces modules interviennent en relation avec le matériel à tester, suivant le programme de tests adapté à ce matériel sous la commande du microordinateur. Ils permettent en particulier de produire des grandeurs électriques, signaux analogiques ou grandeurs logiques (données numériques), qui sont appliquées au matériel à tester et de recevoir pour leur traitement ultérieur des signaux analogiques ou données numériques qui sont fournis en réponse par le matériel à tester.

Toutes les connexions nécessaires sont organisées à partir du microordinateur, suivant les instructions d'un programme introduit dans la mémoire 6, par l'intermédiaire d'un BUS dans lequel on a distingué sur la figure 1 un BUS d'adresse 9, à 16 lignes, un BUS de contrôle bidirectionnel 11 à 4 ligneset un BUS de données bidirectionnelles à 8 lignes.

Chaque testeur qui reçoit un ensemble spécifique de modules, est configuré, tant du point de vue de l'instrumentation que de celui du panneau de contrôle ou des organes de dialogue en fonction de chaque application. Ainsi suivant une caractéristique de l'invention, lorsque l'on veut tester en temps réel un composant électronique à haute intégration, il est possible d'utiliser un module mémoire tampon situé au plus près des broches entrées et sorties de la valise.

L'unité centrale est commandée par un oscillateur 12 qui peut être notamment un oscillateur de 4 ou 8 mégahertz divisé pour engendrer un signal d'horloge biphasé nécessaire aux temporisations utiles lors des échanges et au cadencement du système.

Enfin, l'ensemble micromodulaire microordinateur utilise pour les besoins des tests, des programmes translatables permettant de former des blocs logiciels modulaires et indépendants adaptés aux besoins ou aux applications spécifiques, implantés sur des mémoires mortes (6). Pour obtenir une modularité de fonctionnement, on établit un lien entre tous ces programmes afin de contrôler leur exécution, la gestion mémoire, les entrées et sorties.

Pour réaliser cette opération, on utilise un programme "éditeur de liens" qui assure : les liaisons interprogramme destinées aux échanges, le contrôle de l'intégrité des programmes, l'initialisation des programmes, la réservation d'une partie de la mémoire à ces programmes.

L'ensemble de ces programmes, présenté sous forme modulaire, dispose d'une entête et de deux blocs de définition contenant les "programmes résidants".

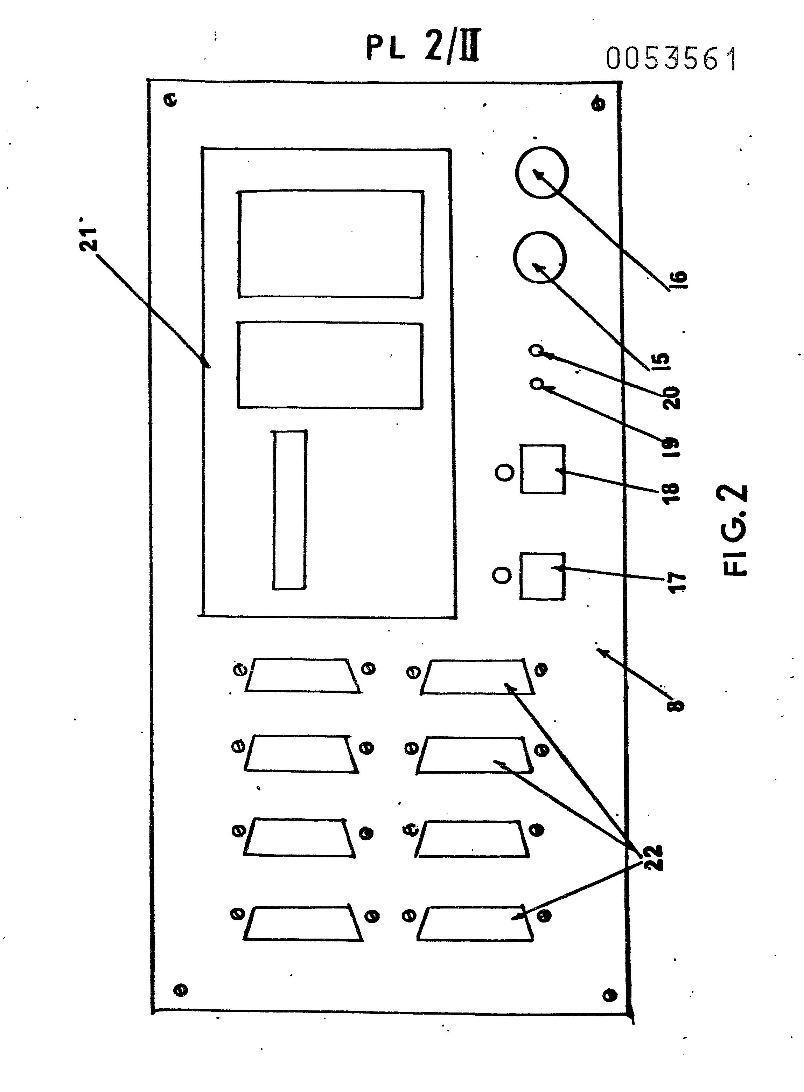

On représenté à la figure 2 l'exemple de réalisation d'un panneau de contrôle 8 et de commande du testeur.

La conception de ce panneau de contrôle peut comprendre un clavier 21 permettant d'établir entre l'opérateur et le testeur un véritable dialogue interactif. Il est bien entendu que ce type de dialogue facilite la présentation et l'exploitation des résultats.

Ce panneau 8 est relié d'une part aux BUS au moyen d'un interface 7 (figure 1) et d'autre part au microordinateur. Dans la formule de base, du testeur, on trouve sur ce panneau l'interrupteur marche-arrêt 15 qui peut être verrouillé au moyen d'une clé, et son voyant lumineux 16.

Les commandes de lancement du test sont figurées par le bouton 17 accompagné d'un voyant, tandis que l'arrêt du test ou la réinitialisation peut être obtenu en agissant sur le bouton 18 accompagné de sa visualisation lumineuse.

Les liaisons avec le système à tester sont représentées par les 8 fiches à broches 22. Le terminal de dialogue 21 comporte par exemple un affichage et un clavier interchangeable, de façon à prendre une configuration différente en fonction des modules d'instrumentation utilisés pour des tests spécifiques.

Dans une version à option, une imprimante peut être directement raccordée à l'unité centrale au moyen d'un interface incorporé.

- 9 -

0053561

Le résultat "bon" de l'application du test sur l'organe à contrôler est sanctionné par l'allumage du voyant 19.

Le résultat "mauvais" de l'application du test est sanctionné par l'allumage du voyant 20.

Dans ses détails la figure 1 illustre une configuration particulière du testeur en valise portable décrit ci-dessus. Les modules d'instrumentation mis en place dans la valise comportent deux cartes logiques respectivement 23 et 24 pour l'entrée et la sortie d'informations sous forme de donnée numériques, qui peuvent être connectées au matériel à tester par les broches 41 et 42, une carte de commande de relais 25 qui peut être connectée directement au matériel à tester par la broche 40, et divers modules de génération et réception de signaux analogiques parmi lesquels on a représenté par exemple un générateur de tension continue32, un générateur de fonctions26, un fréquence-mètre 27, un voltmètre 29. A ces cartes analogiques sont associées une carte de commande de relais 33 qui reçoit ses instructions du microordinateur, pour commander une carte de commutation 28 qui assure les connexions avec la matériel à tester par l'intermédiaire de broches d'entrée et sortie respectivement 45 et 44. Le générateur de tension continue32 peut transmettre le signal qu'il produit soit par l'intermédiaire de ce même commutateur 28 soit directement au matériel à tester par la broche 43. On n'a pas représenté des équipements complémentaires dont est avantageusement pourvu le testeur et qui comprennent essentiellement une sonde montée sur flexible et accessible sur le dessus de la valise. Cette sonde permet une connexion supplémentaire avec le matériel à tester, toujours sur instruction du microordinateur. Elle peut être amenée manuellement par l'opérateur en un point particulier du matériel à tester pour y introduire un signal de tests produit par le testeur ou au contraire pour y prélever un signal à traiter. D'autre part le testeur peut comporter une interface de liaison avec une mémoire externe permettant d'introduire dans une mémoire vive du micro-ordinateur, un programme permettant d'assurer la gestion des différents modules d'instrumentation compris dans le testeur en fonction de chaque application spécifique sur des matériels à tester particuliers. Il peut s'agir notamment de programmes mémorisés sur des cassettes pour lesquelles la valise peut comporter un support et un lecteur approprié.

0053561

Revendications

1. Testeur spécifique modulaire automatisé et portable, caractérisé en ce qu'il comprend des moyens modulaires de test comprenant, pour la production et l'acquisition de grandeurs électriques transmises entre le testeur et le matériel à tester, des cartes interchangeables de généraration de signaux de tests à appliquer à un matériel à tester et de réception de signaux en provenance du matériel à tester, et des cartes d'entrée et sortie de données numériques, des moyens de traitement desdits signaux et desdites données réalisées à partir d'un microordinateur (4) construit autour d'un microprocesseur (5), des moyens de liaison par interface entre le microordinateur et un panneau de contrôle (8), et des organes de dialogue avec le microordinateur comprenant des éléments de visulatisation et de commande destinés à informer l'opérateur et lui permettre de piloter les commandes de tests.

2. Testeur suivant la revendication 1, caractérisé en ce que lesdits moyens modulaires comportent en outre des moyens de commutation (28), placés sous la commande du microordinateur,pour relier alternativement chacune desdites cartes de génération et de réception de signaux à des broches de connexion avec le matériel à tester.

3. Dispositif suivant la revendication 1 ou 2, caractérisé en ce que les moyens modulaires et le microordinateur sont intégrés à l'intérieur d'un boîtier sous forme de valise qui présente sur une face visible le panneau de contrôle et les organes de dialogue, ainsi que des broches de connection entre les moyens modulaires et un matériel à tester.

4. Testeur selon la revendication 3, caractérisé en ce qu'il comporte en outre une sonde placée sous la commande du microordinateur et pouvant être extraite du boîtier à travers une face visible de celui-ci pour être appliqué en un point particulier du matériel à tester, suivant une instruction visualisée par les orgones de dialogue.

5. Testeur suivant la revendication 1 ou 2, caractérisé en ce que les commandes et le dialogue sont réalisés à partir d'un panneau de contrôle interchangeable (8) figurant pour chaque test spécifique et donc pour chaque carte de génération ou de réception de signaux, un dialogue ou des commandes particulières.

6. Testeur suivant la revendication 5, caractérisé en ce que le microordinateur (4) est construit autour d'un microprocesseur (5) associé à une mémoire comprenant un moniteur résidant doté d'un éditeur de liens.

7. Testeur suivant la revendication 5, caractérisé en ce qu'il comporte en outre des moyens de liaison par interface avec un lecteur de programme enregistré pour l'introduction d'un programme de tests spécifiques dans une mémoire vive du microordinateur.

8. Testeur suivant la revendication 1, caractérisé en ce qu'il comporte un oscillateur (12) de 4 ou 8 mégahertz pour la commande en temps du microodinateur

9. Dispositif suivant la revendication 1, caractérisé en ce que parmi les cartes de génération et d'acquisition de grandeurs électriques, il comporte des modules programmables tels que générateur de tension continue ou alternative, générateur de fonction de signaux de synchrotransmission, générateurs et analyseurs de signaux logiques (mots, série ou parallèle), multimètres, fréquencemètres, compteur universel.

10. Testeur suivant la revendication 1, caractérisé en ce qu'il comporte des moyens de communication avec des ordinateurs ou des circuits périphériques, soit spécifiques, soit programmés, par l'intermédiaire de liaison série ou parallèle selon le mode multiple, sous forme d'un module
placé fonctionnellement sous le contrôle du microordinateur.

FIG. 1

FIG. 2